# DEMANDE DE BREVET EUROPEEN

(11) **EP 0 668 597 A1**
(43) Date de publication de la demande: **23.08.1995**
(21) Numéro de dépôt: 95400380.2
(22) Date de dépôt: 22.02.1995
(51) Int. Cl.: H01F 27/38, H02M 3/337, G01R 15/18

(54) **Redresseur de tension à haute fréquence de découpage**

(30) Priorité: 22.02.1994 FR 9402004
(71) Demandeur: SOCIETE GENERALE DE TRAVAUX ELECTRIQUES, F-94210 La Varenne Saint Hilaire (FR)
(72) Inventeur: Kazdaghli, Abdessatar, F-92160 Antony (FR); Le Breton, Philippe, F-92000 Nanterre (FR)
(74) Mandataire: Derambure, Christian

(57) **Abrégé**

L'invention concerne un redresseur de tension à haute fréquence de découpage comprenant un redresseur à absorption sinusoïdale (2) et un convertisseur tension continue/tension continue (3) ; une self de résonance (5) montée sur l'une des branches du primaire ; une capacité (6) en parallèle sur le primaire (8) ; et un dispositif de redressement, ou redresseur (7) en parallèle sur le secondaire (9). Selon l'invention, la self de résonnance (5) est une self à air comprenant un fil électrique gainé d'isolant (10) continu réalisant un enroulement (12) torique et une spire de compensation (11) de même axe que le tore défini par l'enroulement torique (12) et de rayon de l'ordre du cercle générateur du tore.

## Description

L'invention concerne un redresseur de tension à haute fréquence de découpage.

L'invention concerne en particulier un redresseur de tension à haute fréquence de découpage comprenant un redresseur à absorption sinusoïdale et un convertisseur tension continue/tension continue.

De façon connue, le convertisseur DC/DC comprend notamment un transformateur ayant un circuit magnétique et des circuits primaire et secondaire ; une self de résonnance montée sur l'une des branches du primaire ; une capacité en parallèle sur le primaire ; et un dispositif de redressement, ou redresseur en parallèle sur le secondaire.

La fonction d'un redresseur de tension est de convertir une tension alternative (par exemple, 230V à 50 Hertz), en une tension continue (par exemple 48V continu).

Les redresseurs de tension sont utilisés couramment dans tout dispositif branché sur le secteur dont certaines fonctions nécessitent une tension continue.

On peut citer par exemple les dispositifs permettant de charger ou recharger les batteries.

Certains de ces redresseurs doivent pouvoir fournir une puissance importante de l'ordre de 1,5 à 2 Kwatt.

L'encombrement volumique des redresseurs de tension est essentiellement induit par l'importance volumique des transformateurs nécessaires pour pouvoir fournir 1,5 à 2 Kwatt et plus.

Une première technique dite technique de fréquence de découpage, échantillonnant la tension alternative d'entrée à une fréquence de découpage donnée, permet de diminuer sensiblement l'encombrement des redresseurs. En effet, cette technique permet de diminuer la taille des éléments magnétiques et capacitifs en fonction de la fréquence de découpage. Plus la fréquence de découpage est élevée, plus les éléments magnétiques et capacitifs peuvent être réduits.

Cette technique est néanmoins limitée par les pertes dans les semi-conducteurs lors des ouvertures et fermetures commutatives à partir de fréquences de découpage de l'ordre de la centaine de Kilohertz.

Une technique complémentaire dite technique à résonnance permet de réduire sensiblement les pertes dans les semi-conducteurs et d'arriver à des fréquences de l'ordre du MégaHertz.

Cependant, lorsque la fréquence de découpage est de l'ordre du MégaHertz, il se crée des pertes dans les composants inductifs. Ces pertes sont soit magnétiques, soit cuivre.

Les pertes magnétiques sont liées aux matériaux magnétiques que l'on trouve dans l'inductance de résonnance et dans le transformateur.

Les pertes cuivre sont induites d'une part par les bobinages que ce soit celui de l'inductance de résonnance ou les circuits primaires et secondaires du transformateur ; et d'autre part dans les connexions extérieures et les inductances de cablage.

On connait également d'après le document JP-A-3091241 une sonde de ROGOWSKI appliquée à la mesure de courant et servant à mesurer les courants d'un conducteur traversant le centre du tore. Cependant dans ce document elle ne sert pas d'élément passif d'un circuit de puissance et ne joue pas le rôle d'une inductance.

D'autre part, le document "Conference Record of the 1991 IEEE Industry Applications Society Annual Meeting" concerne plus particulièrement un onduleur haute fréquence à résonnance série-parallèle dans lequel la charge connectée derrière le pont de diode (D5, D6, D7, D8) est du type capacitive (figures 3 et 8).

Cependant, le transformateur haute tension utilisé présente un mode de couplage d'enroulement (bien connu) et non de spires.

D'après le document DE-B-1246122 on connait aussi un sytème destiné à éliminer le rayonnement extérieur d'une inductance torique dans lequel on sépare cette dernière en deux tores identiques dont les positions relatives sont telles que l'on peut annuler le champ extérieur. Cependant, cette disposition à deux tores reste relativement complexe.

Enfin, le document "PESC '92 RECORD, June 29, 1992, TOLEDO, SPAIN" décrit un redresseur dont la commutation s'effectue à zéro de courant.

Le but de la présente invention est de pallier les inconvénients ci-dessus en proposant un redresseur de tension à haute fréquence de découpage (par exemple, de l'ordre du MégaHertz) fournissant une puissance importante (par exemple de 1,5 à 2 Kwatt) et dont les pertes magnétiques et cuivre sont sensiblement réduites par rapport à l'art antérieur.

A cet effet, l'invention concerne un redresseur de tension à haute fréquence de découpage comprenant un redresseur à absorption sinusoïdale et un convertisseur tension continue/tension continue. Le convertisseur tension continue/tension continue comprend un transformateur ayant un circuit magnétique, un circuit primaire et un circuit secondaire ; une self de résonnance montée sur l'une des branches du circuit primaire ; une capacité en parallèle sur le circuit primaire ; et un dispositif de redressement, ou redresseur en parallèle sur le circuit secondaire.

Selon l'invention, la self de résonnance est une self à air comprenant un fil électrique continu réalisant un enroulement torique et une spire de compensation de même axe que le tore défini par l'enroulement torique et de rayon de l'ordre du cercle générateur du tore.

L'utilisation d'une self à air a l'avantage de supprimer tout élément magnétique dans la self de résonnance et ainsi de diminuer les pertes magnétiques.

Cependant, en champs lointains, une self à air constitué par un enroulement torique seul génère un rayonnement d'ordinaire canalisé par l'élément magnétique.

Un autre avantage de la présente invention est donc de diminuer voire d'annuler ce rayonnement extérieur par l'utilisation d'une spire de compensation. Cette caractéristique est importante dans la mesure où le rayonnement maximum extérieur est imposé par des normes qu'il convient de respecter pour obtenir l'homologation du redresseur dans certains domaines d'application.

Selon l'invention, les circuits primaire et secondaire du transformateur du redresseur comprennent chacun au moins un bobinage réalisé à partir d'un ruban métallique comprenant une succession d'un même motif ayant un cheminement en "S" et une forme générale rectangulaire. Ce motif comprend un premier sous-motif de forme générale rectangulaire ayant une ouverture centrale rectangulaire et une fente dans un coin et formant la première boucle du "S", et un deuxième sous-motif de forme et de dimensions sensiblement équivalentes au premier sous-motif, raccordé au premier sous-motif par une première ligne de pliage, et formant la deuxième boucle "S". Un motif étant raccordé au motif suivant par une seconde ligne de pliage perpendiculaire à la première ligne de pliage localisée entre le tronçon final du second sous-motif du motif et le tronçon initial du premier sous-motif du motif suivant, les premier et dernier motifs présentant chacun une patte de connexion. Le bobinage est réalisé par pliage en accordéon suivant successivement les première et deuxième lignes de pliage de chaque motif. Les bobinages des primaire et secondaire sont imbriqués, le noyau du circuit magnétique passant par les ouvertures centrales superposées.

L'imbrication quasiment spire à spire du primaire et du secondaire diminue sensiblement les pertes cuivre liées au bobinage dans le transformateur.

Selon l'invention, les pattes de connexion des bobinages des circuits primaire et secondaire sont telles qu'elles permettent des connexions rapprochées du condensateur sur le primaire et du dispositif de redressement, ou redresseur sur le secondaire. Ces connexions rapprochées, en limitant les longueurs de câblage de connexion, limitent les pertes cuivre générées par inductances parasites.

D'autres caractéristiques et avantages de la présente invention résulteront de la description qui va suivre en référence aux dessins annexés dans lesquels :

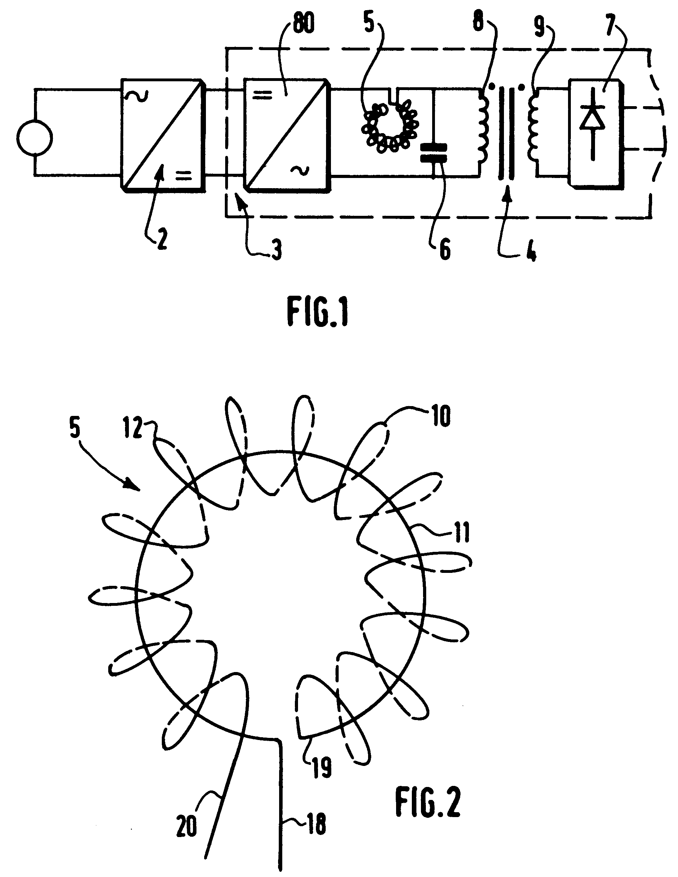

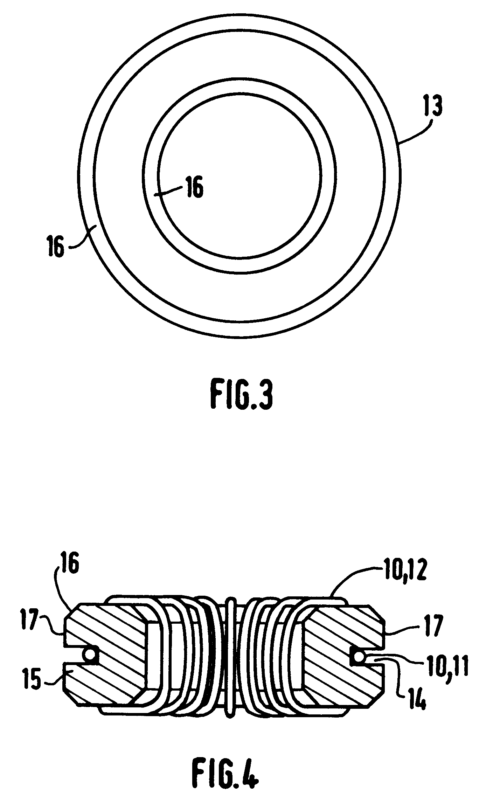

- la figure 1 représente une vue générale schématique partielle du circuit électrique faisant l'objet de la présente invention ;
- la figure 2 est une vue schématique de l'enroulement torique et de la spire de compensation d'une self à air selon l'invention;
- la figure 3 est une vue schématique de dessus du tore utilisé pour la self à air selon l'invention ;

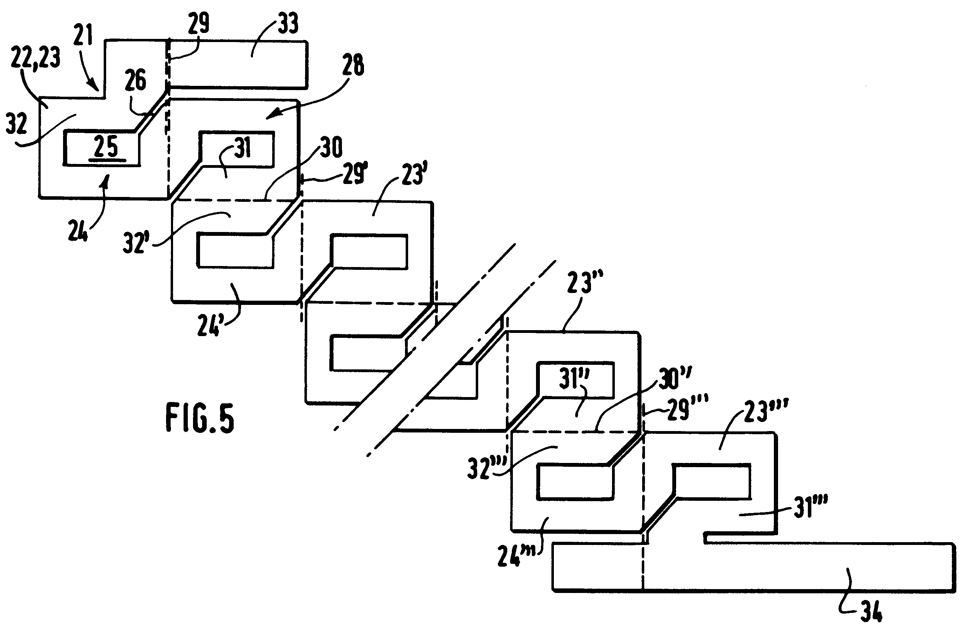

- la figure 4 est une vue schématique en coupe diamétrale de la self à air à spire de compensation selon l'invention ;
- la figure 5 est une vue schématique extérieure d'un bobinage de circuit primaire déplié ;

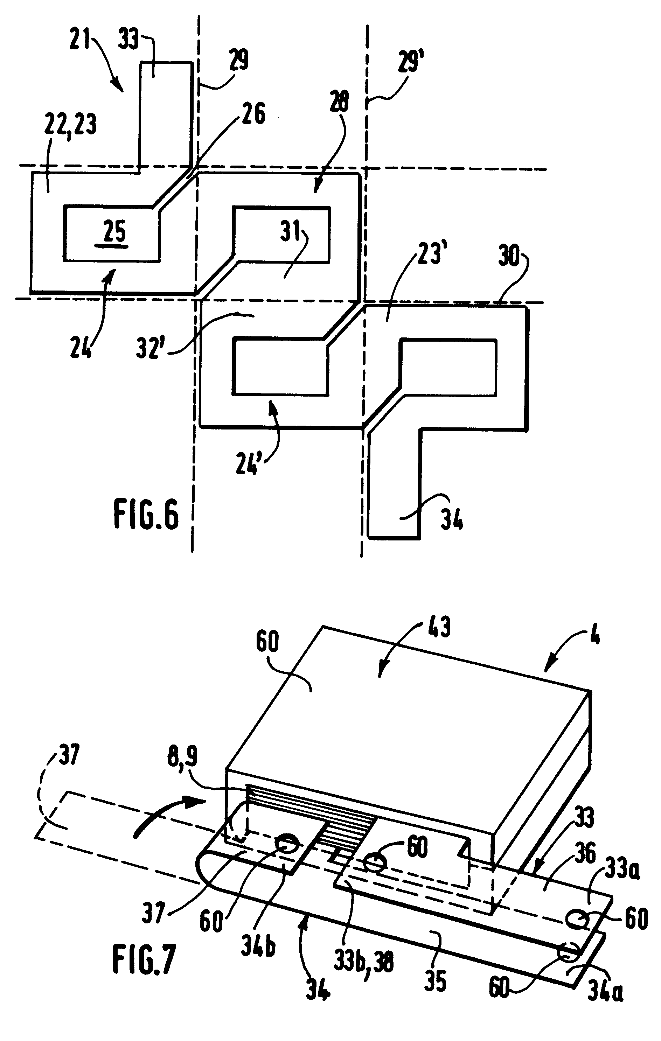

- la figure 6 est une vue schématique extérieure d'un bobinage de circuit secondaire déplié ;
- la figure 7 est une vue schématique extérieure d'un transformateur selon l'invention et en particulier des pattes de connexion du circuit primaire ;
- les figures 8a, 8b sont des vues schématiques de côté et de dessus des moyens de connexion entre les secondaires et le dispositif de redressement, ou redresseur selon l'invention ;
- la figure 9 est une vue schématique en coupe d'un transformateur selon l'invention.

L'invention concerne un redresseur de tension à haute fréquence de découpage, par exemple de l'ordre du MégaHertz pouvant fournir une puissance importante par exemple de l'ordre de 1,5 à 2 KWatt. Ce redresseur de tension peut, par exemple non limitatif, être utilisé pour convertir du 230V alternatif à 50 Hertz (secteur) en 48V continu destiné à recharger les batteries.

Le redresseur de tension à haute fréquence de découpage comprend un redresseur à absorption sinusoïdale 2 destiné à redresser la tension alternative en tension continue. Ce type de redresseur à absorption sinusoïdale travaillant à des fréquences de découpage de l'ordre de la centaine de Kilohertz est connu de l'art antérieur.

Le redresseur de tension à haute fréquence de découpage comprend en outre un convertisseur tension continue/tension continue 3 comprenant un onduleur 80 transformant la tension continue issue du redresseur à absorption sinusoïdale en créneaux de tension ; un transformateur 4 ayant un circuit magnétique 43, un circuit primaire 8 monté en parallèle sur l'onduleur 80 et un circuit secondaire 9 ; une self de résonance 5 montée en série sur une des branches du primaire ; une capacité 6 en parallèle sur le primaire 8 ; et un dispositif de redressement ou redresseur 7 en parallèle sur le secondaire 9.

La self de résonnance 5 est une self à air comprenant un fil électrique 10 avec une gaine isolante réalisant un enroulement 12 torique et une spire de compensation 11 de même axe que le tore défini par l'enroulement torique 12 et de rayon de l'ordre du cercle générateur du tore. Cette self de résonnance 5 ne comprend donc aucun matériau magnétique.

Vu de loin, l'enroulement torique 12 se comporte comme une spire qui provoque un rayonnement extérieur.

Ce rayonnement extérieur est essentiellement dû au fait que la self de résonnance 5 ne comporte plus d'élément magnétique qui d'habitude le canalise.

Pour contrer les effets de ce rayonnement extérieur, la self de résonnance 5 comprend une spire de compensation 11 limitant sensiblement le rayonnement, et donc les perturbations.

D'un point de vue pratique, dans un mode de réalisation de l'invention, l'enroulement torique 12 est réalisé autour d'un tore 13 en matière non magnétique présentant une gorge circulaire 14 radiale dans laquelle est enroulée la spire de compensation 11.

Le tore 13 a une section transversale radiale 15, une forme générale rectangulaire à coins 16 chanfreinés. Le côté externe 17 de la forme rectangulaire présente ladite gorge circulaire radiale 14. Le chanfreinage des coins de la section transversale rectangulaire du tore 13 a pour but d'améliorer les performances de l'enroulement torique 12.

Avantageusement, le fil 10 utilisé pour la réalisation de la self à air 5 à spire de compensation 11 est un fil de Litz connu pour avoir des pertes cuivre limitées.

L'enroulement torique 12 et la spire de compensation 11 s'agencent comme suit :
- la spire de compensation 11 présente à une première extrémité 18 l'une des bornes de la self 5. A une deuxième extrémité 19, la spire de compensation 11 est prolongée par l'enroulement torique 12. L'enroulement torique 12 étant réalisé autour de la spire de compensation 11, de la deuxième extrémité 19 vers la première extrémité 18 de la spire de compensation 11. L'extrémité 20 de l'enroulement torique 12 constitue la deuxième borne de la self 5.

La self à air 5 à spire de compensation 11 selon l'invention permet d'une part la suppression des pertes magnétiques du fait qu'elle ne contient plus aucun élément magnétique, d'autre part la limitation sensible du rayonnement extérieur de l'enroulement torique vu de loin grâce à la spire de compensation 11, enfin, une limitation des pertes cuivre dues à l'utilisation d'un fil de Litz et d'un tore 13 à coins chanfreinés.

Le transformateur 4 du convertisseur tension continue/tension continue 3 comprend des circuits primaire et secondaire 8, 9 comprenant chacun au moins un bobinage 21 réalisé à partir d'un ruban métallique 22 isolé électriquement sur ses faces.

Ce ruban métallique 22 comprend une succession d'un même motif 23 ayant un cheminement en "S" et une forme générale rectangulaire. Chaque motif 23 comprend un premier sous-motif 24 de forme générale rectangulaire ayant une ouverture centrale 25 et une fente 26 dans un coin. Ce premier sous-motif 24 forme la première boucle du "S". Le motif 23 comprend un deuxième sous-motif de forme et de dimensions sensiblement équivalentes au premier sous-motif 24. Ce deuxième sous-motif est raccordé au premier sous-motif 24 par une première ligne de pliage 29 de telle sorte qu'il forme la deuxième boucle "S".

Un motif 23 est raccordé au motif 23' suivant par une seconde ligne de pliage 30 perpendiculaire à la première ligne de pliage 29 disposée entre le tronçon final 31 du second sous-motif 28 du motif 23 et le tronçon initial 32' du premier sous-motif 24' du motif suivant 23'.

Le bobinage 21 est réalisé par pliage en accordéon suivant successivement les première 29 et deuxième 30 lignes de pliage de chaque motif (23, 23', 23", 23"').

En outre, les bobinages des circuits primaire 8 et secondaire 9 sont imbriqués les uns dans les autres, le circuit magnétique passant par les ouvertures centrales 25 superposées.

Un tel pliage permet d'obtenir quatre spires complètes pour cinq épaisseurs de sous-motif d'un même bobinage.

L'imbrication des bobinages du circuit primaire et du circuit secondaire permet une réduction sensible des pertes cuivre associées généralement à un transformateur 4.

Selon l'invention, les bobinages comportent avantageusement un nombre pair de motifs.

Les pertes cuivre interviennent en outre dans la boucle capacitive 40 et sur la liaison du circuit secondaire avec le dispositif de redressement, ou redresseur.

Ces pertes sont fonction croissante de la longueur des câblages de connexion du circuit capacitif et du dispositif de redressement, ou redresseur.

Selon l'invention, les bobinages du circuit primaire et du circuit secondaire comprennent des pattes de connexion 33, 34 agencés de telle manière qu'elles limitent ces pertes. Dans une forme particulière de réalisation non limitative représentée sur la figure 7, la patte 33 du premier motif 23 du bobinage du circuit primaire 8 du transformateur 4 a une forme générale en "L" émergeant perpendiculairement de l'extrémité du tronçon initial 32, et la patte 34 du dernier motif 23"' du bobinage du circuit primaire 8 du transformateur 4 a une forme générale en "T", émergeant perpendiculairement de l'extrémité libre du tronçon final 31"'. Ainsi, lorsque le bobinage est plié, une branche transversale 35 du "T" est en regard de la branche libre 36 du "L" de sorte qu'il forme tous deux les pattes de connexion 33a, 34a destinées à être connectées sur le reste du circuit. L'autre branche transversale 37 du "T", s'étendant initialement à l'opposé de l'angle droit 38 du "L", est ramené vers l'angle droit 38 du "L" pour former en association avec ledit angle droit 38 les pattes de connexion 33b, 34b sur lesquelles va être monté le condensateur 6. Ainsi, la longueur de connexion du circuit capacitif est extrêmement limitée et intégrée aux pattes de connexion du circuit primaire 8 du transformateur 4. Avantageusement, le condensateur 6 est vissé ou soudé directement sur les pattes de connexion 33b, 34b de sorte d'économiser la longueur des fils de connexion normalement nécessaire à la mise en place de cosses de connexion ou menant au support de soudage.

Dans la forme de réalisation représentée sur la figure 7, les extrémités 33b et 34b destinées au condensateur 6 et les extrémités 33a et 34a destinées à être reliées sur le reste du circuit, présentent des trous 60 préformés pour la connexion par vissage.

Sur la figure 7, les deux pattes 33, 34 sont décalées l'une par rapport à l'autre d'une part, du fait du pliage (décalage vertical) ; et d'autre part, du fait qu'il existe un nombre pair de motifs (décalage horizontal).

Selon l'invention, le circuit secondaire 9 peut être formé d'un ou plusieurs bobinages secondaires. Avantageusement, ces bobinages comportent un nombre pair de motifs, de telle sorte que, comme dans le cas du circuit primaire 8, les pattes de connexion 34 et les pattes de connexion 33 sont décalées les unes par rapport aux autres dans une direction horizontale.

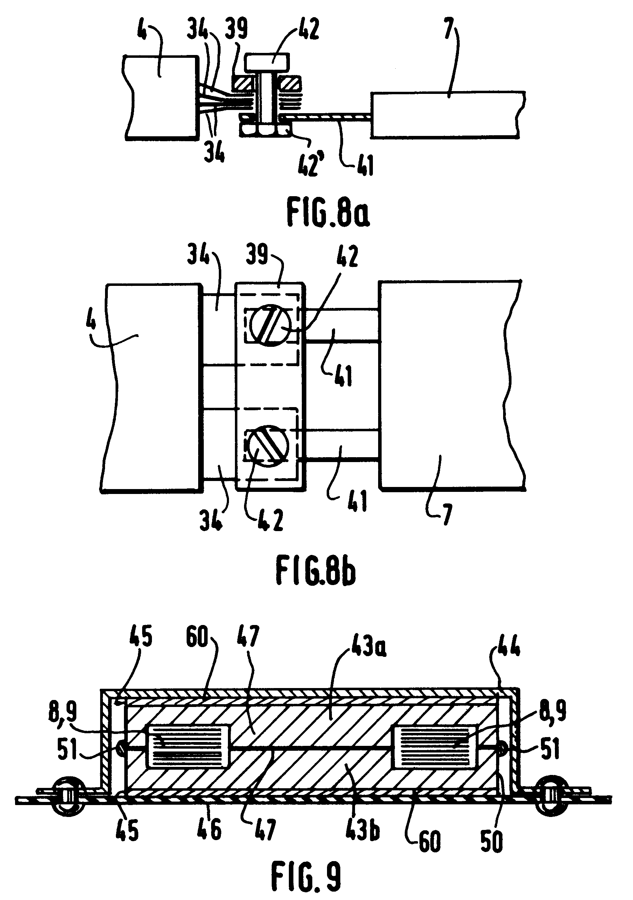

Ainsi, dans le cas de plusieurs secondaires, et comme représenté sur la figure 8, une fois les bobinages du circuit secondaire pliés et imbriqués dans les bobinages du circuit primaire, les pattes 34 sont superposées les unes aux autres décalées horizontalement par rapport aux pattes 33 superposées les unes aux autres. La mise en parallèle des différents bobinages constituants le circuit secondaire est donc largement facilité par la mise en commun des pattes 34 et la mise en commun des pattes 33.

Avantageusement et afin de respecter le mieux possible l'imbrication du circuit primaire avec le circuit secondaire, la connexion du circuit secondaire sur le dispositif de redressement, ou redresseur 7 se fait par l'intermédiaire d'une pièce isolante 42 positionnant exactement les pattes de connexion 34 par rapport aux pattes de connexion 33, 34. Cette position exacte des pattes 34 par rapport aux pattes 33 permet un pliage optimal et donc une imbrication optimale du circuit secondaire 9 dans le circuit primaire 8. En outre, cette pièce isolante 42 facilite le serrage de vis-écrous en évitant la rotation de la bande cuivre lors du serrage. A cet effet, la pièce isolante 42 est avantageusement placée entre la tête de vis et les pattes de connexion 34 du circuit secondaire.

Avantageusement, la connexion avec le dispositif de redressement, ou redresseur se fait par des vis 42 conductrices passant à travers des trous prévus à cet effet dans les pattes 34, 33 passant à travers les trous prévus à cet effet dans la plaque isolante 39 et passant à travers des trous prévus à cet effet dans les pattes de connexion 41 du dispositif de redressement, ou redresseur, un écrou vissé 42' sur la vis 42 permettant de maintenir l'ensemble serré.

De cette façon, et en utilisant un dispositif de redressement, ou redresseur dont le câblage a été réduit de façon optimale, on limite sensiblement les pertes cuivre dans les connexions du transformateur avec le dispositif de redressement, ou redresseur. Le dispositif de redressement, ou redresseur est choisi parmi tous les dispositifs connus sur la base d'un critère de pertes cuivre minimal. Par exemple, non limitatif, le dispositif de redressement, ou redresseur peut être un pont de diode.

Avantageusement, le circuit magnétique 43 du transformateur est en ferrite et forme un boîtier 50 avec un noyau central 47 passant à travers les ouvertures 25. Le boîtier 50 présente deux surfaces 60 d'échange thermique, et deux faces latérales opposées ouvertes pour permettre le passage des pattes de connexion 33, 34 des circuits primaire 8 et secondaire 9.

Dans une forme de réalisation particulière représentée sur la figure 9, le boîtier 50 est monté en deux parties symétriques 43a, 43b maintenues ensemble à l'aide de points de colle 51. Ce système permet, avec des éléments de ferrite 43a, 43b standard identiques, de réaliser des bobinages de circuits primaire et de secondaire ayant un nombre de spires double de celui qu'on obtiendrait avec un élément standard unique 43a pourvu d'un couvercle.

La réduction sensible du transformateur 4 du fait de l'utilisation de très hautes fréquences induit des problèmes relatifs à la dissipation calorifique. En effet, les surfaces d'échange du transformateur étant sensiblement diminuées du fait de la diminution du transformateur 4 (de l'ordre de dix fois moins), il est important de pourvoir au moins une des surfaces de dissipation d'un radiateur 46.

Selon l'invention, le transformateur est fixé sur le radiateur 46 par l'intermédiaire d'une bride de fixation 44.

Avantageusement, il est intercalé entre le boîtier de ferrite 50 et le radiateur 46 et entre la bride 44 et le boîtier 50, une couche 45 d'isolant électrique à grand coefficient de transfert thermique. En outre avantageusement la couche 45 limite les contraintes mécaniques pour la ferrite fragile. Cette couche 45 isolante peut être notamment du film silicone ou équivalent.

Avantageusement et par souci de limiter l'encombrement et le nombre de pièces constitutives, le radiateur 46 peut être dimensionné pour accueillir et refroidir le dispositif de redressement, ou redresseur.

## Revendications

1. Redresseur de tension à haute fréquence de découpage comprenant un redresseur à absorption sinusoïdale (2) et un convertisseur tension continue/tension continue (3), ledit convertisseur tension continue/tension continue (3) comprenant un onduleur (80) sur lequel est monté en sortie un transformateur (4) ayant un circuit magnétique (43), un circuit primaire et un circuit secondaire (9) ; une self de résonance (5) montée en série sur l'une des branches du primaire ; une capacité (6) en parallèle sur le primaire (8) ; et un dispositif de redressement, ou redresseur (7) en parallèle sur le secondaire (9),
caractérisé en ce que la self de résonnance (5) est une self à air comprenant un fil électrique gainé d'isolant (10) continu réalisant un enroulement (12) torique et une spire de compensation (11) de même axe que le tore défini par l'enroulement torique (12) et de rayon de l'ordre du cercle générateur du tore.

2. Redresseur selon la revendication 1, caractérisé en ce que l'enroulement torique est réalisé autour d'un tore (13) en matière non magnétique présentant une gorge circulaire (14) radiale dans laquelle est enroulée la spire de compensation (11).

3. Redresseur selon la revendication 2, caractérisé en ce que le tore (13) a une section transversale radiale (15), une forme générale rectangulaire à coins (16) chanfreinés, le côté externe (17) de la forme rectangulaire présentant ladite gorge circulaire radiale (14).

4. Redresseur selon l'une quelconque des revendications 1 à 3, caractérisé en ce que la spire de compensation (11) présente à une première extrémité (18) l'une des bornes de la self et à une deuxième extrémité (19) l'enroulement torique (12), ledit enroulement torique (12) étant réalisé autour de la spire de compensation (11), de la deuxième extrémité (19) vers la première extrémité (18) de la spire de compensation (11), l'extrémité (20) de l'enroulement torique (12) constituant la deuxième borne de la self.

5. Redresseur selon l'une quelconque des revendications 1 à 4, caractérisé en ce que le fil (10) utilisé pour la réalisation de la self à air (5) à spire de compensation (11) est du fil de Litz.

6. Redresseur selon l'une quelconque des revendications 1 à 5, caractérisé en ce que lesdits circuits primaire et secondaire (8, 9) comprennent chacun au moins un bobinage (21) réalisé à partir d'un ruban métallique (22) à faces isolées électriquement comprenant une succession d'un même motif (23) ayant un cheminement en "S" et une forme générale rectangulaire, comprenant un premier sous-motif (24) de forme générale rectangulaire ayant une ouverture centrale rectangulaire (25) ayant une fente (26) dans un coin formant la première boucle du "S" et un deuxième sous-motif (28) de forme et de dimensions sensiblement équivalente au premier sous-motif (24) par une première ligne de pliage (29) et formant la deuxième boucle "S", un motif (23) étant raccordé au motif (23') suivant par une seconde ligne de pliage (30) perpendiculaire à la première ligne de pliage (29) localisée entre le tronçon final (31) du second sous-motif (28) dudit motif (23) et le tronçon initial (32') du premier sous-motif (24') dudit motif suivant (23'), les premier et dernier motifs présentant chacun une patte de connexion (33, 34), le bobinage (21) étant réalisé par pliage en accordéon suivant successivement les première (29) et deuxième (30) lignes de pliage de chaque motif, les bobinages des circuits primaire (8) et secondaire (9) étant imbriqués, le circuit magnétique passant par les ouvertures centrales (25) superposées.

7. Redresseur selon la revendication 6, caractérisé en ce que le nombre de motif (23, 23', 23'', 23"') des bobinages des circuits primaires (8) et secondaires (9) est un nombre pair.

8. Redresseur selon la revendication 6 ou 7, caractérisé en ce que le premier motif (23) et le dernier motif (23"') d'un bobinage du circuit primaire (8) de transformation (4) comprenne chacun une patte de connexion (33b, 34b) entre lesquels le condensateur (6) est directement monté afin de limiter la longueur de la boucle capacitive (40).

9. Redresseur selon l'une quelconque des revendications 6 à 8, caractérisé en ce que le premier motif (23) et le dernier motif (23"') d'un bobinage du circuit primaire (8) du transformateur 4 comprennent chacun une patte de connexion (33a, 34a) destinés à relier le circuit primaire au reste du convertisseur.

10. Redresseur selon l'une quelconque des revendications 8 et 9, caractérisé en ce que la patte (33) du premier motif (23) du bobinage du circuit primaire (8) du transformateur (4) a une forme générale en "L" émergeant perpendiculairement de l'extrémité libre du tronçon initial (32) et la patte (34) du dernier motif (23"') du bobinage du circuit primaire (8) du transformateur (4) a une forme générale en "T", émergeant perpendiculairement de l'extrémité libre du tronçon final (31"'), de telle manière qu'une branche transversale du "T" soit en regard de la branche libre (36) du "L" formant tous deux les pattes de connexion (33a, 34a), et l'autre branche transversale (37) du "T" ramené vers l'angle droit (38) du "L" forme en association avec ledit angle droit (38) les pattes en connexion (33b, 34b) pour le condensateur (6).

11. Redresseur selon l'une quelconque des revendications 1 à 10, caractérisé en ce que ledit circuit secondaire comprend plusieurs bobinages raccordés en parallèle.

12. Redresseur selon l'une quelconque des revendications 1 à 11, caractérisé en ce que la connexion du dispositif de redressement, ou redresseur (7) en parallèle sur le secondaire (9) se fait par vissage à l'aide de vis (42) et écrous sur une plaque isolante de centrage (39) des pattes de connexion (33, 34) du secondaire (9) et des pattes de connexion (41) du dispositif de redressement, ou redresseur (7).

13. Redresseur selon l'une quelconque des revendications 6 à 12, caractérisé en ce que le circuit magnétique (43) du transformateur est en ferrite et forme un boîtier (50) avec un noyau central (47) passant à travers les ouvertures (25) des bobinages et deux surfaces (60) d'échange thermique, ledit boîtier ayant deux faces latérales opposées ouvertes pour permettre le passage des pattes de connexion (33, 34).

14. Redresseur selon la revendication 13, caractérisé en ce que le boîtier (50) est monté en deux parties symétriques (43a, 43b) maintenues ensemble à l'aide de points de colle (51).

15. Redresseur selon la revendication 14, caractérisé en ce que le boîtier (50) est rapporté sur un radiateur (46) à l'aide d'une bride de fixation (44).

16. Redresseur selon la revendication 15, caractérisé en ce qu'est intercalé entre le boîtier (50) et le radiateur (46) et entre la bride (44) et le boîtier (50), une couche (45) d'isolant électrique à grand coefficient de transfert thermique et limitant les contraintes mécaniques sur la ferrite du boîtier (50), notamment du film silicone.
